# EUROPEAN PATENT SPECIFICATION

(11) **EP 2 233 978 B1**
(45) Date of publication and mention of the grant of the patent: **28.11.2018**
(21) Application number: 08863406.8
(22) Date of filing: 12.12.2008
(51) Int. Cl.: G03F 7/11, G03F 7/09, C08F 216/06, C08F 220/10, C08F 226/10, H01L 21/027

(54) **COMPOSITION FOR FORMATION OF ANTI-REFLECTIVE FILM, AND PATTERN FORMATION METHOD USING THE COMPOSITION**
ZUSAMMENSETZUNG ZUR ERZEUGUNG EINES ANTIREFLEXFILMS UND DIE ZUSAMMENSETZUNG VERWENDENDES STRUKTURERZEUGUNGSVERFAHREN
COMPOSITION DE FORMATION D'UN FILM ANTIRÉFLÉCHISSANT ET PROCÉDÉ DE FORMATION D'UN MOTIF À L'AIDE DE LA COMPOSITION

(30) Priority: 26.12.2007 JP 2007334891
(43) Date of publication of application: 29.09.2010
(73) Proprietor: Merck Patent GmbH, 64293 Darmstadt (DE)
(72) Inventor: NOYA, Go, Kakegawa-shi Shizuoka 437-1412 (JP); AKIYAMA, Yasushi, Kakegawa-shi Shizuoka 437-1412 (JP); TAKANO, Yusuke, Tokyo 176-0004 (JP)
(74) Representative: Féaux de Lacroix, Stefan
(86) International application number: PCT/JP2008/072681
(87) International publication number: WO 2009/081773

(56) References cited:
- EP-A1- 1 806 621
- WO-A2-02/25374
- JP-A- 2002 097 231
- JP-A- 2007 178 974
- JP-A- 2007 219 504
- JP-A- 2007 256 928
- JP-A- 2007 293 332
- US-A- 5 830 623
- Wu-Song Huang ET AL: "<title>New 193nm top antireflective coatings for superior swing reduction</title>", Proceedings of SPIE, vol. 6153, 9 March 2006 (2006-03-09), pages 61530S-61530S-8, XP055156068, ISSN: 0277-786X, DOI: 10.1117/12.656641

## Description

### TECHNICAL FIELD

The present invention relates to a composition for forming a top anti-reflection coating. Specifically, this invention relates to a composition for forming an anti-reflection coating provided on the top surface of a photoresist film when the photoresist film is subjected to exposure in a photolithographic process for manufacture of flat panel displays (FPDs) such as liquid crystal displays, semiconductor devices, charge-coupled devices (CCDs), color filters or the like. The present invention also relates to a pattern formation method employing the above top anti-reflection coating composition, and further relates to a top anti-reflection coating formed thereby.

### BACKGROUD ART

In the manufacture of flat panel displays (FPDs) such as liquid crystal displays, semiconductor devices, charge-coupled devices (CCDs), color filters or the like, photolithographic technique has been used. For example, in a photolithographic process for producing integrated circuits, a positive- or negative-working photoresist is coated on a substrate, then baked to remove the solvent, subsequently exposed to radiation such as UV light, deep UV light, electron beam or X-ray, and finally developed to form a photoresist pattern.

However, in many cases, the substrate used in the process has a high reflectance. Accordingly, in the exposure step, light passing through the photoresist layer is often reflected by the substrate and then reenters the photoresist layer again, so that the light is applied to the photoresist layer even in areas not expected to be exposed. As a result, the aimed pattern often cannot be obtained or the obtained pattern may have defects. Further, back reflection of light at the interface between the substrate and the photoresist layer often causes a standing-wave effect to corrugate the photoresist layer, and consequently serious troubles may occur in controlling the line width of the photoresist pattern. These phenomena are remarkable when light having a shorter wavelength is used in the exposure step for forming a finer pattern.

For coping with those problems, various methods have been studied and developed. Examples of them include a method in which a dye having an absorption band in the wavelength range of light for exposure is dispersed in the photoresist, a method in which a bottom anti-reflection coating (BARC) or a top anti-reflection coating (TARC) is provided, a top surface imaging (TSI) method, and a multilayer resist (MLR) method. Among them, the method employing a bottom anti-reflection coating is most popularly adopted at present. As the bottom anti-reflection coatings, there are known inorganic anti-reflection coatings and organic ones. The inorganic coatings can be formed by known methods in which inorganic or metal materials are deposited according to, for example, CVD (chemical vapor deposition) process, vapor deposition process or sputtering process. The organic coatings can be formed by known methods in which the substrate is coated, for example, with an organic polymer solution with dissolving or dispersing a dye or with a solution or dispersion of a polymer dye containing chromophores chemically combined with its polymer skeleton. For example, EP-A-1 845 416 relates to coating compositions for photolithography. An example of an underlying coating composition is prepared with anthracene methacrylate/2-hydroxyethyl methacrylate copolymer. Further, US 2007/0148586 relates to hard mass compositions for resist underlayer films and methods for producing semiconductor integrated circuit devices using the same. The underlayer film comprises a polyhydroxystyrene-co-anthracene oxystyrene-copolymer.

As for the top anti-reflection coating, it also has an important function. When the substrate coated with a photoresist is subjected to exposure, the photoresist film is irradiated with (1) incident light, (2) light reflected by the substrate and (3) light back-reflected toward the substrate from the interface of the photoresist after reflected from the substrate and, therefore, the optical path lengths thereof determine the amount of exposure for forming the photoresist pattern. On the other hand, light waves of (1) to (3) cause interference in the photoresist film. In view of that, the proper amount of exposure is varied if the photoresist film is provided with a top anti-reflection coating.
For example, US 5,830,623, which relates to a pattern lithography method, discloses a top anti-reflection coating. One type of photo cross-linking hydrous polymers that are used to prepare the anti-reflection coating composition are water-soluble polymers bonded to photo sensitive groups. Further examples for anti-reflection coatings are given in US 2002/012789, which relates to organic anti-reflective coating polymers, anti-reflective coating compositions comprising the same and the method of the preparation thereof. For example, the polymer for the anti-reflective coating composition comprises an anthracene group-containing monomer and a hydrophilic monomer like 2-hydroxyethyl acrylate. WO 02/25374 relates to an anti-reflective composition comprising a plurality of cross-linked polymeric particles having chromophores which can be anthracenyl groups. Finally, EP 1 806 621 A1 relates to coating compositions that comprise a resin component, wherein the predominant portion of the resin component comprising one or more resins that are at least substantially free of fluorine.

Meanwhile, a term "swing curve" means a curved graph in which the amount of exposure needed to form a desired pattern (i.e., energy threshold, hereinafter often referred to as "Eth") and the photoresist thickness are plotted on the vertical and horizontal axes, respectively, and a term "swing ratio" means the quotient obtained by dividing the amplitude of the swing curve (i.e., difference between the maximum value and the minimum value of the curve) by the average amount of light exposure. The more gradual the swing curve slopes and the smaller the swing ratio is, the more favorably the photoresist film is formed.

For the purpose of improving the swing curve or the swing ratio, it is known to provide a top anti-reflection coating. For example, the top anti-reflection coating is known to be formed by coating the top surface of the photoresist film with a composition containing a fluorine compound such as perfluorooctanic acid or perfluorooctanesulfonic acid. Wu-Song Huang et al., for instance, disclose 193nm top antireflective coatings for superior swing reduction (Wu-Song Huang et al., Proceedings of SPIE, Vol. 6153, 9 March 2006, apges 61530S-61530S-8). The coatings comprise acrylic acid and fluorine-comprising monomers. The top anti-reflection coating can reduce light interference caused by variation of the photoresist thickness and improve the swing curve or the swing ratio. In order to lower the amplitude of the swing curve by forming an anti-reflection coating on the top surface of the photoresist, it is effective that the top anti-reflection coating should have a low refractive index or absorb light adequately.

To obtain an anti-reflection coating having a low refractive index, fluorine-containing substances are generally used as the materials thereof. However, compounds of those substances are very expensive, which is a problem.

In the meantime, a method is proposed in which a dye is incorporated in the top anti-reflection coating to prevent multiple reflections (see, Patent document 1). Although the coating contains the dye in a considerable amount, thickness of the top anti-reflection coating tends to be too large because of low extinction coefficient. There is room for improvement in this method.
Japanese Patent No. 3,334,304

### DISCLOSURE OF INVENTION

### PROBLEM TO BE SOLVED BY THE INVENTION

It is an object of the present invention to provide, at low cost, a top anti-reflection coating with high extinction coefficient to reduce the swing effect caused by variation in thickness of a photoresist film used in a semiconductor production process, particularly, in a process comprising exposure by use of a KrF excimer laser.

### MEANS FOR SOLVING PROBLEM

The present invention resides in a top anti-reflection coating composition used in a photolithographic process for forming a pattern by use of light having a wavelength of 160 to 260 nm, particularly, at 248 nm; which comprises a solvent and an anthracene skeleton-containing polymer having a hydrophilic group, wherein said anthracene skeleton-containing polymer is a copolymer derived from an anthracene skeleton-containing monomer and methacrylic acid, the molar ratio of the hydrophilic group-containing monomer being not less than 85 mole%.

The present invention also resides in a pattern formation method comprising the steps of: coating a substrate with a photoresist composition to form a photoresist film; coating said photoresist film with a top anti-reflection coating composition which comprises a solvent and a copolymer derived from methacrylic acid and an anthracene skeleton-containing monomer; drying said composition; conducting exposure by use of light having a wavelength of 160 to 260 nm; and then carrying out development with an alkali developer, wherein the anti-reflection coating is removed with
the developer, wherein the molar ratio of methacrylic acid is not less than 75 mole%.

### EFFECT OF THE INVENTION

The present invention enables to provide, at low cost, a composition for forming a top anti-reflection coating having a low refractive index, realizing a gradual swing curve and giving a small swing ratio. Accordingly, it becomes possible to produce photoresist patterns excellent in shape at low cost.

### BRIEF DESCRIPTION OF THE DRAWINGS

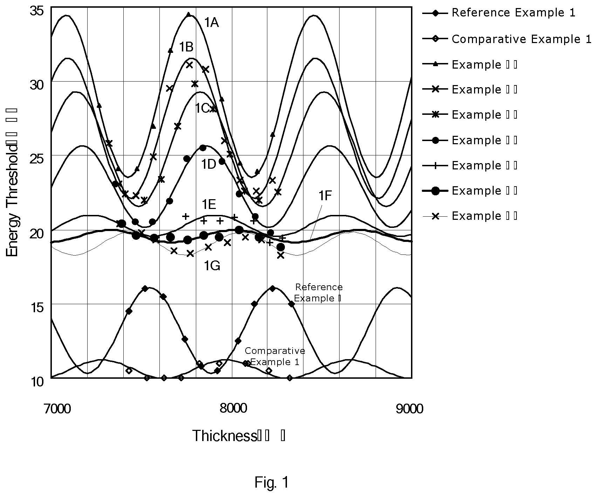

Figure 1 exhibits graphs indicating swing curves of Examples 1A to 1G, Comparative Example 1 and Reference Example 1.

### BEST MODE FOR CARRYING OUT THE INVENTION

The top anti-reflection coating composition according to the present invention comprises a solvent and an anthracene skeleton-containing polymer having a hydrophilic group, wherein said anthracene skeleton-containing polymer is a copolymer derived from an anthracene skeleton-containing monomer and methacrylic acid, the molar ratio of the hydrophilic group-containing monomer being not less than 85 mole%. Since having an anthracene skeleton, this polymer compound absorbs light having the wavelength range of 160 to 260 nm, in which an ArF or KrF laser emits. Accordingly, the composition functions as an advantageous anti-refiection coating. Further, since also having a hydrophilic group, the anthracene skeleton-containing polymer in the composition of the present invention is easily dissolved in an aqueous solution or the like, and hence can be readily removed when the photoresist is subjected to development treatment.

It is indispensable for the anthracene skeleton-containing polymer to comprise an anthracene skeleton and a hydrophilic group. For example, it may be a hydrophilic group-containing polymer in which an anthracene skeleton is bound to its side chain or a polymer in which an anthracene skeleton is included in its main chain and a hydrophilic group is bound to the anthracene skeleton or to a linking group connecting to the skeleton. Further, the hydrophilic group may be bound to any carbon in the anthracene.

The anthracene skeleton-containing polymer is a copolymer derived from an anthracene
skeleton-containing monomer and methacrylic acid.

There is no particular restriction on the anthracene skeleton-containing monomer as long as it contains an anthracene skeleton and is polymerizable with methacrylic acid. For example, it may comprise an anthracene skeleton connecting to an unsaturated bond-containing group such as an acrylic ester group or a vinyl group. The monomer preferably comprises a repeating unit represented by the following formula (I): 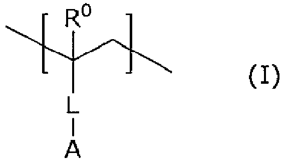 in which R⁰ is hydrogen or methyl; L is a divalent linking group having 1 to 8 carbon atoms; and A is an anthracene-containing group represented by the following formula (A): 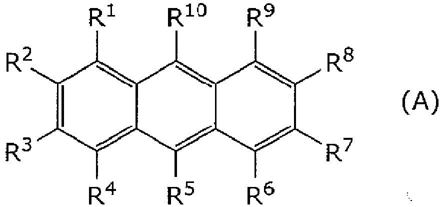 in which one of R¹ to R¹⁰ is connected to L, and each of the others is independently selected from the group consisting of:
- H,
- (CH₂)ₙ₁OR',
- (CH₂)ₙ₁NHR',
- (OCH₂CH₂)ₙ₂OR',
- (CH₂)ₙ₁SO₃R",
- (CH₂)ₙ₁COOR",
- (CH₂)ₙ₁CONH₂, and
- (CH₂)ₙ₁SO₂NH₂
in which n1 is an integer of 0 to 4; n2 is an integer of 1 to 40; R' is H, an alkyl group having 1 to 8 carbon atoms or an acyl group having 1 to 8 carbon atoms; and R" is H or an alkyl group having 1 to 8 carbon atoms.

The above copolymer may be a random copolymer or a block copolymer. Either or each of the hydrophilic group-containing monomer and the anthracene skeleton-containing monomer may be a combination of two or more kinds of monomers.

In consideration of ensuring solubility to a solvent or a developer, the molar ratio of the hydrophilic group-containing monomer is not less than 85 mole%.

As described above, the anthracene skeleton-containing polymer used in the present invention comprises a hydrophilic group and therefore has high solubility to a developer and the like. Specifically, the polymer according to the present invention has a solubility to water in the range of preferably not less than 0.1 wt%, more preferably not less than 0.15 wt%, and most preferably not less than 0.2 wt%. Further, since a top anti-reflection coating formed from the composition of the present invention is preferably removed in development treatment, its solubility to 2.38% aqueous solution of tetramethylammonium hydroxide, which is a developer generally used, is preferably not less than 1.0 wt%, more preferably not less than 2.0 wt%, most preferably not less than 5.0 wt%. It must be noted that, if the polymer contained in the composition has poor solubility to the solvent, such as water, the resultant anti-reflection coating often cannot have a thickness enough to realize desired effects. Further, if having poor solubility to the developer, the polymer often cannot be fully removed in the developing process and partially remain on the substrate.

The top anti-reflection coating composition of the present invention contains a solvent. The solvent can be freely selected as long as it can dissolve the naphthalene compound, the polymer, and various other optional additives described later. However, since the composition of the present invention is often spread on the surface of a photoresist film beforehand formed, it preferably does not damage the film. In view of that, the solvent is preferably water or an organic solvent. If water is used as the solvent, it is preferred to remove organic impurities, metal ions and the like from the water by distillation, by ion-exchange treatment, by filtration treatment or by various adsorption treatments.

Examples of the organic solvent include: (a) hydrocarbons, such as n-hexane, n-octane and cyclohexane; (b) alcohols, such as methyl alcohol, ethyl alcohol and isopropyl alcohol; (c) ketones, such as acetone and methyl ethyl ketone; (d) esters, such as methyl acetate, ethyl acetate and ethyl lactate; (e) ethers, such as diethyl ether and dibutyl ether; and (f) other polar solvents, such as dimethylformamide, dimethyl sulfoxide, methyl cellosolve, cellosolve, butyl cellosolve, cellosolve acetate, alkylcellosolve acetate, butylcarbitol and carbitol acetate. The solvent can be freely selected from those according to the aimed properties.

It is also possible to use mixtures of those organic solvents or of water and the organic solvents. For example, the mixture comprises not less than 60 wt% but less than 99.9 wt% of a hydrocarbon having 5 to 20 carbon atoms and not less than 0.1 wt% but less than 40 wt% of an alcohol having 1 to 20 carbon atoms. This mixed solvent is particularly preferred because it hardly dissolves the resist film. Also preferred is a mixed organic solvent which comprises ether in an amount of 50 wt% or more. Particularly preferred is a mixed solvent comprising not less than 50 wt% of ether having 2 to 20 carbon atoms and the rest amount of a hydrocarbon having 5 to 20 carbon atoms and/or an alcohol having 1 to 20 carbon atoms. That mixture is also hardly dissolves the resist film. Further, still also preferred is a mixture of 90 wt% or more of water with a lower alcohol such as methyl alcohol, ethyl alcohol or isopropyl alcohol.

The top anti-reflection coating composition of the present invention can further contain a basic compound, if necessary, as long as it does not impair the effects of the present invention. If the anthracene skeleton-containing polymer has an acidic group, the basic compound can react with the acidic group to form a salt and, as a result, to improve the solubility. Consequently, the basic compound can increase the content of the anthracene skeleton-containing polymer in the composition, and accordingly enables to form a thick top anti-reflection coating. Examples of the basic compound include ammonia, amines such as alkyl amines, aromatic amines and alkanol amines (e.g., mono-ethanol amine), and tetramethylammonium hydroxide.

The top anti-reflection coating composition of the present invention may furthermore contain optional additives. The additives are incorporated so as to improve coatability of the composition onto the photoresist film and/or to improve the properties of the resultant anti-reflection coating. Examples of the optional additives include surfactants. The surfactants include, for example, (a) anionic surfactants, such as alkyldiphenyletherdisulfonic acid, alkyldiphenylethersulfonic acid, alkylbenzenesulfonic acid, polyoxyethylenealkylethersulfuric acid, alkylsulfuric acid, and ammonium salts or organic amine salts thereof; (b) cationic surfactants, such as hexadecyltrimethylammonium hydroxide; (c) nonionic surfactants, such as polyoxyethylenealkylether (e.g., polyoxyethylenelaurylether, polyoxyethyleneoleylether, polyoxyethylenecetylether), polyoxyethylene-fatty acid diester, polyoxyethylene-fatty acid monoester, polyoxyethylene-polyoxypropylene block polymer, and acetylene glycol derivatives; and (d) amphoteric surfactants, such as 2-alkyl-N-carboxymethyl-N-hydroxyethyl-imidazoliniumbetaine, and amidopropylhydroxysulfonebetaine laurylate. Those examples, however, by no means restrict the usable surfactants. Besides the above, thickening agents, colorants such as dyes, acids and bases are also usable as the additives. The contents of these additives are determined in consideration of effects thereof, but are generally 0.01 to 1 wt.%, preferably 0.1 to 0.5 wt.% based on the total weight of the composition.

The top anti-reflection coating composition according to the present invention can be used in the same manner as a conventional one. In other words, it is unnecessary to change the pattern formation process considerably when the composition of the present invention is practically used. The pattern formation method employing the top anti-reflection coating composition of the present invention is concretely explained below.

First, a photoresist composition is spread by a known coating method such as spin-coating to form a photoresist composition layer on a substrate such as a silicon or glass substrate, which may be pre-treated, if necessary. Before the photoresist composition is applied, a bottom anti-reflection coating may be previously formed under the photoresist by coating. The bottom anti-reflection coating can improve the section shape and the exposure margin in cooperation with the top anti-reflection coating to be formed from the composition of the present invention.

Any known photoresist composition can be used in the pattern formation method of the present invention. Representative examples of the photoresist compositions usable in the present invention include: positive-working photoresist compositions, such as a composition comprising a quinonediazide type photosensitive substance and an alkali-soluble resin, and a chemically amplified photoresist composition; and negative-working photoresist compositions, such as a composition comprising a photosensitive functional group-containing polymer such as polyvinyl cinnamate, a composition comprising an azide compound such as an aromatic azide compound or a bisazide compound with a cyclized rubber, a composition comprising a diazo resin, a photo-polymerizable composition comprising an addition-polymerizable unsaturated compound, and a chemically amplified negative-working photoresist composition.

Examples of the quinonediazide type photosensitive substance used in the positive-working photoresist composition comprising a quinonediazide type photosensitive substance and an alkali-soluble resin include: 1,2-benzoquinonediazide-4-sulfonic acid, 1,2-naphthoquinonediazide-4-sulfonic acid, 1,2-naphthoquinonediazide-5-sulfonic acid, and sulfonic esters or amides thereof. Examples of the alkali-soluble resin include: novolak resin, polyvinyl phenol, polyvinyl alcohol, and copolymers of acrylic acid or methacrylic acid. The novolak resin is preferably prepared from one or more phenols such as phenol, o-cresol, m-cresol, p-cresol and xylenol in combination with one or more aldehydes such as formaldehyde and paraformaldehyde.

Either positive- or negative-working chemically amplified photoresist composition can be used in the pattern formation method of the present invention. The chemically amplified photoresist generates an acid when exposed to radiation, and the acid serves as a catalyst to promote chemical reaction by which solubility to a developer is changed within the areas irradiated with the radiation to form a pattern. For example, the chemically amplified photoresist composition comprises an acid-generating compound, which generates an acid when exposed to radiation, and an acid-sensitive functional group-containing resin, which decomposes in the presence of acid to form an alkali-soluble group such as phenolic hydroxyl or carboxyl group. The composition may comprise an alkali-soluble resin, a crosslinking agent and an acid-generating compound.

The photoresist composition layer formed on the substrate is prebaked, for example, on a hot plate to remove solvent contained in the composition, to form a photoresist film. The prebaking temperature depends on the solvent and the photoresist composition, but is normally 20 to 200°C, preferably 50 to 150°C.

On the formed photoresist film, the top anti-reflection coating composition of the present invention is applied by spin-coating and the like and then the solvent is evaporated to form a top anti-reflection coating. The top anti-reflection coating thus obtained has a thickness of generally 3 to 50 nm, preferably 10 to 45 nm, more preferably 10 to 40 nm.

In the above process, before the photoresist composition layer formed on the substrate is completely dried, the top anti-reflection coating composition may be applied thereon. The solvent of the top anti-reflection coating composition can be removed by the prebaking described above.

The top anti-reflection coating thus formed can realize a refractive index of generally 1.40 to 1.60, preferably 1.45 to 1.55. Specifically, the top anti-reflection coating according to the present invention can have the above low refractive index even at a short wavelength of 160 to 260 nm. For example, it can have a refractive index of preferably 1.60 or less, more preferably 1.55 or less at 248 nm. Further, the top anti-reflection coating of the present invention can realize a high extinction coefficient at a short wavelength of 160 to 260 nm. In fact, it can have an extinction coefficient of preferably 0.1 to 0.5, more preferably 0.15 to 0.4 at 248 nm. Since having the above refractive index or extinction coefficient, the top anti-reflection coating of the present invention exhibits excellent performance as a top anti-reflection coating with a low refractive index.

The photoresist film is then exposed through a mask, if necessary, to light having the wavelength range of 160 to 260 nm, preferably, to KrF excimer laser beam.

After the exposure, baking treatment may be carried out, if necessary, and then development such as paddle development is carried out to form a photoresist pattern. The photoresist film is developed with an alkali developer. Since a hydrophilic group is bound to the anthracene skeleton-containing compound contained in the top anti-reflection coating composition of the present invention, the anti-reflection coating is easily removed with the developer. There are instances in which an anthracene skeleton-containing compound is used in a bottom anti-reflection coating, it is not taken into account in those instances to remove the coating in the development treatment. In contrast, the present invention provides a top anti-reflection coating improved in solubility to a solvent, particularly, to a solvent that hardly damages the photoresist film. Therefore the present invention draws a line between the prior art intended for providing the bottom anti-reflection coating.

Examples of the alkali developer used in the present invention include an aqueous solution of sodium hydroxide or tetramethylammonium hydroxide (TMAH). After the development, the photoresist pattern is rinsed (washed) with a rinse solution, preferably, pure water, if necessary. The photoresist pattern thus-formed is employed as a photoresist for etching, plating, ion diffusion or dyeing, and then, if necessary, peeled away.

The thickness of the photoresist pattern is properly determined according to the aimed use, but is in the range of generally 0.1 to 2.5 µm, preferably 0.2 to 1.5 µm.

The photoresist pattern obtained by the pattern formation method of the present invention is then further fabricated or processed according to the aimed use. The pattern formation method of the present invention by no means restricts the subsequent procedures, and hence the photoresist pattern can be fabricated or processed in known manners.

The pattern formed by the method of the present invention can be employed for the manufacture of flat panel displays (FPDs) such as liquid crystal displays, semiconductor devices, charge-coupled devices (CCDs), color filters and the like, in the same manner as patterns formed by the conventional method are employed for.

The present invention is further explained by use of the following examples.

### Example 1

An anthracene skeleton-containing compound of the formula (Ia): 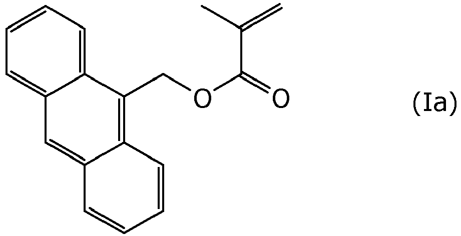 and methacrylic acid were mixed in a molar ratio of 9.4:90.6 (i.e., 25:75 by weight), and polymerized in a mixture of 2,2'-azobisisobutyronitrile/propylene glycol monomethyl ether. The obtained solid product was recrystallized and dried to obtain an anthracene skeleton-containing polymer A.

The polymer A was dissolved in a concentration of 1.5 wt% in a water-organic solvent mixture of 0.03 wt% monoethanol amine, 15 wt% ethyl alcohol and pure water, to prepare a top anti-reflection coating composition. The obtained composition was then applied on a silicon substrate by using a spin-coater (Mark 8 [trademark], manufactured by Tokyo Electron Ltd.) at 1500 rpm, and soft-baked at 90°C for 60 seconds to form a coating film of 28 nm thickness. The refractive index and extinction coefficient of the obtained coating film were measured at 248 nm by using an ellipsometer (VUV-302 [trademark], manufactured by J.A. Woollam (Japan) Co., Inc.), to find 1.514 and 0.302, respectively.

### Example 1A

Ten silicon substrates were individually coated by using a spin-coater (Mark® 8, manufactured by Tokyo Electron Ltd.) with a chemically amplified positive-working photoresist composition (DNC®-5, manufactured by AZ Electronic Materials (Japan) K.K.), which contained a photo acid-generating compound and a resin having a polyhydroxystyrene polymer skeleton, at various rotation speeds to form photoresist films with thicknesses of 740 to 830 nm at intervals of 10 nm. Thereafter, the substrates were subjected to soft-baking at 130°C for 60 seconds, to obtain ten substrates coated with the resist.

To obtain samples, the ten obtained substrates coated with the photoresist of different thicknesses were individually coated by using a spin-coater (Mark® 8, manufactured by Tokyo Electron Ltd.) with the above top anti-reflection coating composition at various rotation speeds to form the resultant films with thickness of 36 nm.

### Examples 1B to 1G

The procedure of Example 1A was repeated except for changing the conditions of coating the above top anti-reflection coating composition, to produce samples of Examples 1B to 1G, whose top anti-reflection coatings had thicknesses of 32, 28, 24, 18, 5, 15 and 13.5 nm, respectively.

### Comparative Example 1

Monoethanol amine and an aqueous solution of a fluorine-containing polymer having a weight average molecular weight of 6200 and comprising a repeating unit (x):

-[CH₂CF(OCF₂CF₂CF₂COOH)]ₙ- (x)

were mixed so that the molar ratio between carboxyl groups (acid) in the fluorine-containing polymer and the monoethanol amine (base) was 1:0.1. The fluorine-containing polymer with partially converted into monoethanol amine salt was mixed with pure water and an aqueous solution of alkylsulfonic acids (mixture of alkylsulfonic acids whose alkyl groups contained 10 to 18 carbon atoms) as a surfactant. A top anti-reflection coating composition consisting of 2.1 wt% of the fluorine-containing polymer partially converted into monoethanol amine salt, 0.1 wt% of the alkylsulfonic acids, and 97.8 wt% of water was prepared. The prepared composition was applied on a silicon substrate by using a spin-coater (Mark® 8, manufactured by Tokyo Electron Ltd.) at 1500 rpm, and soft-baked at 90°C for 60 seconds to form a coating film of 44 nm thickness. The refractive index and extinction coefficient of the obtained coating film were measured at 248 nm by using an ellipsometer (VUV-302®, manufactured by J.A. Woollam (Japan) Co., Inc.), to find 1.445 and 0, respectively.

To obtain samples of Comparative Example 1, the procedure of Example A1 was repeated except for applying the above-prepared top anti-reflection coating composition and for changing its thickness into 43 nm.

### Reference Example 1

As Reference Example 1, DNC-5 resist films were formed without forming top anti-reflection coatings. Ten silicon substrates were individually coated by using a spin-coater (Mark® 8, manufactured by Tokyo Electron Ltd.) with DNC-5 at various rotation speeds to form the resultant photoresist films with thicknesses of 740 to 830 nm at intervals of 10 nm. Thereafter, the substrates were subjected to soft-baking at 130°C for 60 seconds, to obtain ten substrates coated with the resist.

### Measurement of swing curve and swing ratio

The samples of Examples 1A to 1G, Comparative Example 1 and Reference Example 1 were individually subjected to whole image exposure, then to baking treatment at 120°C for 60 seconds, and subsequently to development treatment. Thereafter, the Eth of each developed substrate was measured to obtain swing curves shown in Figure 1. The swing ratios obtained from the curves were as set forth in Table 1. As a result, it was found that the swing ratio varied according to the thickness and became the minimum at the thickness of 15 nm in this case.

**Table 1**

| | Thickness (nm) | Swing ratio |
|---|---|---|
| Ex. 1A | 36 | 38 |
| Ex. 1B | 32 | 36 |
| Ex. 1C | 28 | 31 |
| Ex. 1D | 24 | 24 |
| Ex. 1E | 18.5 | 7 |
| Ex. 1F | 15 | 4.3 |
| Ex. 1G | 13.5 | 8 |
| Com. 1 | 43 | 12 |
| Ref. 1 | - | 44 |

## Claims

1. A pattern formation method comprising the steps of: coating a substrate with a photoresist composition to form a photoresist film; coating said photoresist film with a top anti-reflection coating composition, which comprises a solvent and a copolymer derived from methacrylic acid and an anthracene skeleton-containing monomer; drying said composition; conducting exposure by use of light having a wavelength of 160 to 260 nm; and then carrying out development with an alkali developer, wherein the anti-reflection coating is removed with the developer, wherein the molar ratio of methacrylic acid is not less than 75 mole-%.

2. The method according to claim 1, wherein said anthracene skeleton-containing polymer comprises the repeating unit represented by the following formula (I): 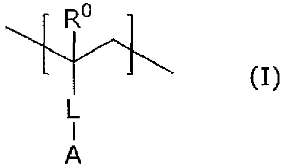 in which R⁰ is hydrogen or methyl; L is a divalent linking group having 1 to 8 carbon atoms; and A is an anthracene-containing group represented by the following formula (A): 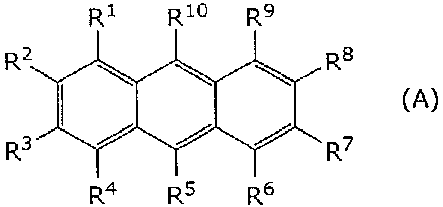 in which one of R¹ to R¹⁰ is connected to L, and each of the others is independently selected from the group consisting of:
- H,
- (CH₂)ₙ₁OR',
- (CH₂)ₙ₁NHR',
- (OCH₂CH₂)ₙ₂OR',
- (CH₂)ₙ₁SO₃R",
- (CH₂)ₙ₁COOR",
- (CH₂)ₙ₁CONH₂, and
- (CH₂)ₙ₁SO₂NH₂
in which n1 is an integer of 0 to 4; n2 is an integer of 1 to 40; R' is H, an alkyl group having 1 to 8 carbon atoms or an acyl group having 1 to 8 carbon atoms; and R" is H or an alkyl group having 1 to 8 carbon atoms.

3. The method according to claim 1 or 2, wherein the top anti-refiection coating composition further comprises a polymer other than said anthracene skeleton-containing polymer.

4. The method according to any of claims 1 to 3, wherein in the top anti-reflection coating composition said solvent is water, an organic solvent or a mixture of water and an organic solvent.

5. The pattern formation method according to claim 1, wherein the formed top anti-reflection coating has a thickness of 3 nm to 50 nm and has an extinction coefficient of 0.1 to 0.5 at 248 nm.

6. A top anti-reflection coating composition used in a photolithographic process for forming a pattern by use of light having a wavelength of 160 to 260 nm; which comprises a solvent and an anthracene skeleton-containing polymer having a hydrophilic group, wherein said anthracene skeleton-containing polymer is a copolymer derived from an anthracene skeleton-containing monomer and methacrylic acid, the molar ratio of the hydrophilic group-containing monomer being not less than 85 mole-%.

7. The top anti-reflection coating composition according to claim 6, wherein said anthracene skeleton-containing polymer comprises the repeating unit represented by the following formula (I): 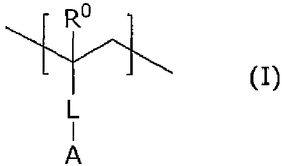 in which R⁰ is hydrogen or methyl; L is a divalent linking group having 1 to 8 carbon atoms; and A is an anthracene-containing group represented by the following formula (A): 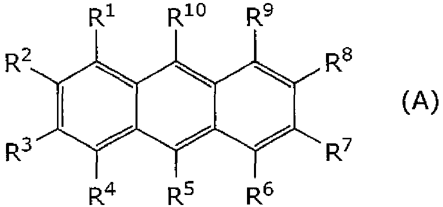 in which one of R¹ to R¹⁰ is connected to L, and each of the others is independently selected from the group consisting of:
- H,
- (CH₂)ₙ₁OR',
- (CH₂)ₙ₁NHR',
- (OCH₂CH₂)ₙ₂OR',
- (CH₂)ₙ₁SO₃R",
- (CH₂)ₙ₁COOR",
- (CH₂)ₙ₁CONH₂, and
- (CH₂)ₙ₁SO₂NH₂
in which n1 is an integer of 0 to 4; n2 is an integer of 1 to 40; R' is H, an alkyl group having 1 to 8 carbon atoms or an acyl group having 1 to 8 carbon atoms; and R" is H or an alkyl group having 1 to 8 carbon atoms

8. The top anti-reflection coating composition according to any of claims 6 or 7, further comprising a polymer other than said anthracene skeleton-containing polymer.

9. The top anti-reflection coating composition according to any of claims 6 to 8, wherein said solvent is water, an organic solvent or a mixture of water and an organic solvent.

## Patentansprüche

1. Musterbildungsverfahren umfassend die Schritte:
Beschichten eines Substrats mit einer Photolackzusammensetzung, um einen Photolackfilm zu bilden; Beschichten des Photolackfilms mit einer oberen Antireflexbeschichtungs-Zusammensetzung, die ein Lösungsmittel und ein Copolymer umfasst, welches von Methacrylsäure und einem Anthracenskelett-enthaltenden Monomer abgeleitet ist; Trocknen der Zusammensetzung; Durchführen einer Belichtung unter Verwendung von Licht mit einer Wellenlänge von 160 bis 260 nm; und dann Durchführen einer Entwicklung mit einem alkalischen Entwickler, wobei die Antireflexbeschichtung mit dem Entwickler entfernt wird, wobei der molare Anteil von Methacrylsäure nicht weniger als 75 mol-% ist.

2. Verfahren gemäß Anspruch 1, wobei das Anthracenskelett-enthaltende Polymer eine Wiederholungseinheit umfasst, die durch die folgende Formel (I) dargestellt wird: 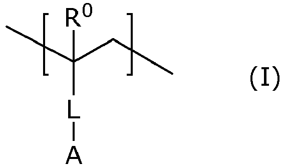 in der R⁰ Wasserstoff oder Methyl ist; L eine divalente Verbindungsgruppe mit 1 bis 8 Kohlenstoffatomen ist; und A eine Anthracen-enthaltende Gruppe ist, die durch die folgende Formel (A) dargestellt wird: 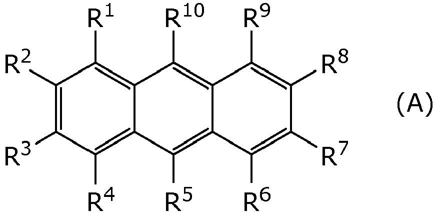 in der eines von R¹ bis R¹⁰ mit L verbunden ist, und jedes von den anderen unabhängig ausgewählt ist aus der Gruppe bestehend aus:
- H,
- (CH₂)ₙ₁OR',
- (CH₂)ₙ₁NHR',
- (OCH₂CH₂)ₙ₂OR',
- (CH₂)ₙ₁SO₃R",
- (CH₂)ₙ₁COOR",
- (CH₂)ₙ₁CONH₂, und
- (CH₂)ₙ₁SO₂NH₂
in welchen n1 eine natürliche Zahl von 0 bis 4 ist; n2 eine natürliche Zahl von 1 bis 40; R' H, eine Alkylgruppe mit 1 bis 8 Kohlenstoffatomen oder eine Acylgruppe mit 1 bis 8 Kohlenstoffatomen ist; und R" H oder eine Alkylgruppe mit 1 bis 8 Kohlenstoffatomen ist.

3. Verfahren gemäß Anspruch 1 oder 2, wobei die obere Antireflexbeschichtungs-Zusammensetzung weiterhin ein Polymer umfasst, welches sich vom Anthracenskelett-enthaltenden Polymer unterscheidet.

4. Verfahren gemäß einem der Ansprüche 1 bis 3, wobei in der oberen Antireflexbeschichtungs-Zusammensetzung das Lösungsmittel Wasser, ein organisches Lösungsmittel oder eine Mischung von Wasser und einem organischen Lösungsmittel ist.

5. Musterbildungsverfahren gemäß Anspruch 1, wobei die gebildete obere Antireflexbeschichtung eine Dicke von 3 nm bis 50 nm und einen Extinktionskoeffizienten von 0,1 bis 0,5 bei 248 nm hat.

6. Obere Antireflexbeschichtungs-Zusammensetzung, die in einem photolithographischen Verfahren zur Bildung eines Musters durch Verwendung von Licht mit einer Wellenlänge von 160 bis 260 nm verwendet wird; welche ein Lösungsmittel und ein Anthracenskelett-enthaltendes Polymer mit einer hydrophilen Gruppe umfasst, wobei das Anthracenskelett-enthaltende Polymer ein Copolymer ist, welches von einem Anthracenskelett-enthaltenden Monomer und Methacrylsäure abgeleitet ist, wobei der molare Anteil des hydrophile Gruppen enthaltenden Monomers nicht weniger als 85 mol-% ist.

7. Obere Antireflexbeschichtungs-Zusammensetzung gemäß Anspruch 6, wobei das Anthracenskelett-enthaltende Polymer die Wiederholungseinheit umfasst, die durch die folgende Formel (I) dargestellt wird: 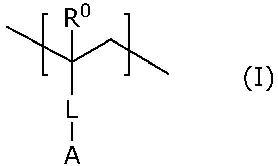 in welcher R⁰ Wasserstoff oder Methyl ist; L eine divalente verbindende Gruppe mit 1 bis 8 Kohlenstoffatomen ist; und A eine Anthracen enthaltende Gruppe ist, welche durch die folgende Formel (A) dargestellt wird: 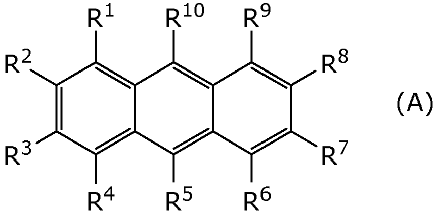 in welcher eines von R¹ bis R¹⁰ mit L verbunden ist, und jedes von den anderen unabhängig ausgewählt ist aus der Gruppe bestehend aus:
- H,
- (CH₂)ₙ₁OR',
- (CH₂)ₙ₁NHR',
- (OCH₂CH₂)ₙ₂OR',
- (CH₂)ₙ₁SO₃R",
- (CH₂)ₙ₁COOR",
- (CH₂)ₙ₁CONH₂, und
- (CH₂)ₙ₁SO₂NH₂
in welchen n1 eine natürliche Zahl von 0 bis 4 ist; n2 eine natürliche Zahl von 1 bis 40 ist; R' H, eine Alkylgruppe mit 1 bis 8 Kohlenstoffatomen oder einer Acylgruppe mit 1 bis 8 Kohlenstoffatomen ist; und R" H oder eine Alkylgruppe mit 1 bis 8 Kohlenstoffatomen ist.

8. Obere Antireflexbeschichtungs-Zusammensetzung gemäß einem der Ansprüche 6 oder 7, weiterhin umfassend ein Polymer, welches sich von dem Anthracenskelett-enthaltenden Polymer unterscheidet.

9. Obere Antireflexbeschichtungs-Zusammensetzung gemäß einem der Ansprüche 6 bis 8, wobei das Lösungsmittel Wasser, ein organisches Lösungsmittel oder eine Mischung aus Wasser und einem organischen Lösungsmittel ist.

## Revendications

1. Procédé de formation d'un motif comprenant les étapes consistant à :
revêtir un substrat d'une composition de résine photosensible pour former un film de résine photosensible ;
revêtir ledit film de résine photosensible d'une composition de revêtement antireflet supérieur, qui comprend un solvant et un copolymère issu d'acide méthacrylique et d'un monomère contenant un squelette anthracène ;
sécher ladite composition ;
mettre en oeuvre l'exposition par l'utilisation de lumière ayant une longueur d'onde de 160 à 260 nm ; et ensuite
effectuer le développement avec un agent de développement alcalin,
dans lequel le revêtement antireflet est enlevé avec l'agent de développement, dans lequel la proportion molaire d'acide méthacrylique n'est pas inférieure à 75 % en mole.

2. Procédé selon la revendication 1, dans lequel ledit polymère contenant un squelette anthracène comprend le motif répété représenté par la formule (I) suivante : 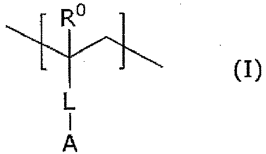 dans lequel R⁰ est un atome d'hydrogène ou un groupe méthyle ; L est un groupe de liaison divalent ayant 1 à 8 atomes de carbone ; et A est un groupe contenant l'anthracène représenté par la formule (A) suivante : 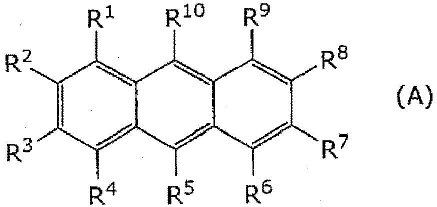 dans lequel l'un de R¹ à R¹⁰ est relié à L et chacun des autres est indépendamment choisi dans le groupe constitué par :
- H,
- (CH₂)ₙ₁OR',
- (CH₂)ₙ₁NHR',
- (OCH₂CH₂)ₙ₂OR',
- (CH₂)ₙ₁SO₃R",
- (CH₂)ₙ₁COOR",
- (CH₂)ₙ₁CONH₂ et
- (CH₂)ₙ₁SO₂NH₂
dans lesquels n1 est un nombre entier de 0 à 4 ; n2 est un nombre entier de 1 à 40 ; R' est H, un groupe alkyle ayant 1 à 8 atomes de carbone ou un groupe acyle ayant 1 à 8 atomes de carbone ; et R" est H ou un groupe alkyle ayant 1 à 8 atomes de carbone.

3. Procédé selon la revendication 1 ou 2, dans lequel la composition de revêtement antireflet supérieur comprend en outre un polymère autre que ledit polymère contenant un squelette anthracène.

4. Procédé selon l'une quelconque des revendications 1 à 3, dans lequel dans la composition de revêtement antireflet supérieur ledit solvant est l'eau, un solvant organique ou un mélange d'eau et d'un solvant organique.

5. Procédé de formation d'un motif selon la revendication 1, dans lequel le revêtement antireflet supérieur formé a une épaisseur de 3 nm à 50 nm et a un coefficient d'extinction de 0,1 à 0,5 à 248 nm.

6. Composition de revêtement antireflet supérieur utilisée dans un processus photolithographique pour la formation d'un motif par l'utilisation de lumière ayant une longueur d'onde de 160 à 260 nm ; qui comprend un solvant et un polymère contenant un squelette anthracène ayant un groupe hydrophile, dans laquelle ledit polymère contenant un squelette anthracène est un copolymère issu d'un monomère contenant un squelette anthracène et d'acide méthacrylique, la proportion molaire du monomère contenant un groupe hydrophile n'étant pas inférieure à 85 % en mole.

7. Composition de revêtement antireflet supérieur selon la revendication 6, dans laquelle ledit polymère contenant un squelette anthracène comprend le motif répété représenté par la formule (I) suivante : 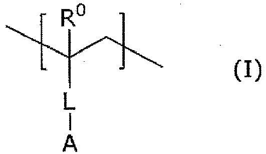 dans lequel R⁰ est un atome d'hydrogène ou un groupe méthyle ; L est un groupe de liaison divalent ayant 1 à 8 atomes de carbone ; et A est un groupe contenant l'anthracène représenté par la formule (A) suivante : 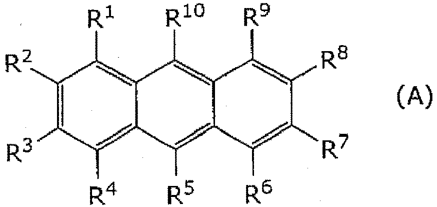 dans lequel l'un de R¹ à R¹⁰ est relié à L et chacun des autres est indépendamment choisi dans le groupe constitué par :
- H,
- (CH₂)ₙ₁OR',
- (CH₂)ₙ₁NHR',
- (OCH₂CH₂)ₙ₂OR',
- (CH₂)ₙ₁SO₃R",
- (CH₂)ₙ₁COOR",
- (CH₂)ₙ₁CONH₂ et
- (CH₂)ₙ₁SO₂NH₂
dans lesquels n1 est un nombre entier de 0 à 4 ; n2 est un nombre entier de 1 à 40 ; R' est H, un groupe alkyle ayant 1 à 8 atomes de carbone ou un groupe acyle ayant 1 à 8 atomes de carbone ; et R" est H ou un groupe alkyle ayant 1 à 8 atomes de carbone.

8. Composition de revêtement antireflet supérieur selon l'une quelconque des revendications 6 ou 7, comprenant en outre un polymère autre que ledit polymère contenant un squelette anthracène.

9. Composition de revêtement antireflet supérieur selon l'une quelconque des revendications 6 à 8, dans laquelle ledit solvant est l'eau, un solvant organique ou un mélange d'eau et d'un solvant organique.
